# DEMANDE DE BREVET EUROPEEN

(11) **EP 0 550 324 A1**
(43) Date de publication de la demande: **07.07.1993**
(21) Numéro de dépôt: 92403512.4
(22) Date de dépôt: 21.12.1992
(51) Int. Cl.: H01R 9/26, H01R 9/24, H01R 13/514

(54) **Bornier pour appareil d'automatisation**

(30) Priorité: 30.12.1991 FR 9116397
(71) Demandeur: AEG SCHNEIDER AUTOMATION, F-75016 Paris (FR)
(72) Inventeur: Chabert, Jean-Marie, F-06560 Valbonne (FR); Goletto, André, F-06600 Antibes (FR)
(74) Mandataire: Carias, Alain

(57) **Abrégé**

Bornier pour appareil d'automatisation, notamment pour automate programmable, fixé de manière amovible et électriquement connecté à un module d'interface.

La paroi latérale (30) du corps (21) du bornier qui est située du côté des ouvertures (26) de passage pour les conducteurs souples (27) reliés aux organes du système automatisé comprend un volet pivotant (31).

## Description

La présente invention concerne un bornier pour appareil d'automatisation, plus particulièrement pour automate programmable, comprenant un corps de bornier amovible susceptible d'être fixé et électriquement connecté à un module électronique de traitement ou module d'interface de l'appareil d'automatisation.

Un tel bornier, connu d'après le brevet FR-2 544 556, comporte des bornes à vis, d'une part, reliées électriquement à des éléments de connexion propres au module et, d'autre part, susceptibles de recevoir et serrer des extrémités de conducteurs reliés à des organes du système automatisé dont on souhaite acquérir l'état ou, en fonction d'un programme préétabli, commander le fonctionnement. Les bornes de serrage offrent, vers l'avant, des ouvertures d'accès à un outil tel qu'un tournevis et, latéralement, des ouvertures de passage pour les extrémités des conducteurs à serrer. Le corps de bornier présente de plus une goulotte latérale pour loger le faisceau de conducteurs, ainsi qu'une paroi de fermeture avant et des parois latérales.

Les termes "avant" et "arrière" utilisés ici qualifient des éléments respectivement situés vers l'opérateur ou à l'opposé de celui-ci dans la position normale d'utilisation de l'appareil.

Il est souhaitable que l'opérateur puisse câbler et mettre en oeuvre facilement un bornier du type décrit.

L'invention a notamment pour but de faciliter la connexion, le logement et la protection des conducteurs d'un tel bornier. Elle a le cas échéant pour autre but de réduire l'encombrement latéral du bornier.

Selon l'invention, la paroi latérale du corps de bornier située du côté des ouvertures d'introduction pour les conducteurs comprend un volet pivotant latéralement autour d'un axe vertical. De préférence, le volet est appliqué en cours de fermeture sur le faisceau de conducteurs selon une direction sensiblement parallèle à la direction d'introduction des conducteurs dans les ouvertures des bornes afin de presser le faisceau dans un sens confirmant la connexion ; le volet peut porter intérieurement des inscriptions relatives au câblage. Lorsque la paroi de fermeture avant est une porte pivotante, le volet pivotant et la porte pivotante tournent autour d'axes verticaux parallèles, la fermeture de la porte venant confirmer celle du volet.

Un exemple non limitatif de réalisation de l'invention va à présent être décrit en regard des figures.
La figure 1 représente, en perspective, un automate programmable muni de borniers conformes à l'invention ;
Les figures 2, 3 et 4 montrent le bornier dans les positions respectives d'utilisation normale, de câblage et de mise en pression des conducteurs après câblage.

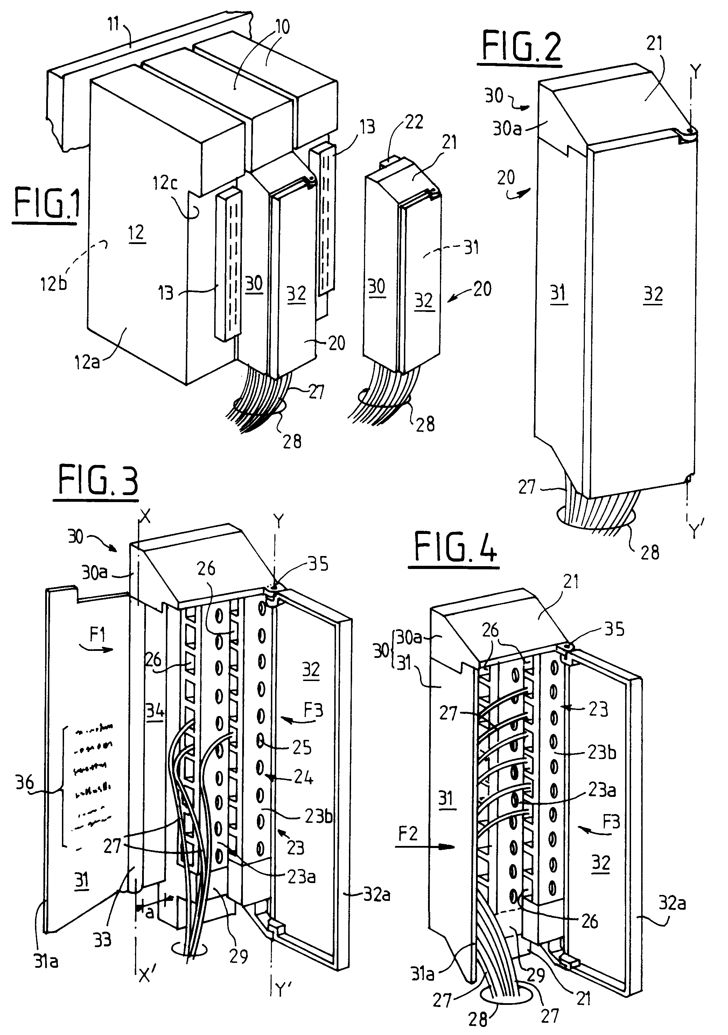

L'automate programmable illustré par la figure 1 comprend plusieurs modules d'interface électroniques 10 de traitement, accrochés et fixés par des moyens non représentés à un support arrière 11 tel qu'une platine ou un socle. Chaque module, par exemple à fonction d'entrée ou de sortie, renferme dans un boîtier 12 à parois latérales 12a, paroi arrière 12b et paroi avant 12c, une électronique de traitement organisée au moyen d'un ou plusieurs circuits imprimés portant des composants appropriés. De la paroi avant 12c dépasse un connecteur 13 relié au circuit imprimé, lequel circuit est lui-même relié électriquement à sa partie arrière, via un connecteur non représenté, à une structure de communication reliant les modules entre eux ou à un processeur commun.

Sur la paroi avant 12c du module est fixé, de manière connue, un bornier 20 comprenant un corps de bornier 21 et un connecteur arrière 22 destiné à coopérer avec le connecteur 13 du module. Le corps de bornier 21 comprend des séries 23 de bornes 24 de serrage et de connexion, accessibles de l'avant à travers des ouvertures 25 par un outil manipulé par l'opérateur. Deux séries de bornes 23a, 23b décalées latéralement et en profondeur ont été représentées.

Chaque borne 24 reçoit, dans une ouverture latérale 26 d'axe horizontal, l'extrémité dénudée d'un ou deux conducteurs souples électriques ou un conducteur optique 27 relié à un organe, tel qu'un capteur ou un organe d'actionnement, du système automatisé. On constate que les conducteurs 27 de chaque série de bornes forment un faisceau 28 logé dans une goulotte verticale 29, disposée au moins en partie latéralement aux séries de bornes, du corps de bornier 21, le faisceau 28 sortant verticalement de la goulotte.

Le corps 21 présente des parois latérales 30 et une paroi avant 32. La paroi 30 située du côté des ouvertures latérales de passage 26 est formée au moins partiellement par un volet pivotant 31. La paroi avant 32 est formée par une porte pivotante. Le volet pivotant 31 et la porte pivotante 32 pivotent tous deux autour d'axes parallèles et verticaux X-X', Y-Y', leur pivotement étant limité par des éléments de butée. L'axe X-X' est matérialisé par une charnière 33 venue de moulage avec le volet 31 et une aile fixe 34 de raccordement au corps de bornier 21. L'axe Y-Y' est matérialisé par des pivots 35.

Dans la position fermée du bornier 20 (figure 2), le volet 31 et la porte 32 sont jointifs par leurs arêtes libres 31a, 32a, tandis que le volet 31 constitue la majeure partie de la paroi latérale 30 du corps de bornier 21, en se situant dans le plan de la partie restante 30a de la paroi 30 et dans le plan de la paroi latérale 12a du module. Des éléments de recouvrement, d'encliquetage ou analogues peuvent être prévus pour confirmer la fermeture du volet 31 par rapport à la partie fixe du corps 21 et/ou pour que la porte 32 confirme la position fermée du volet 31.

On constate que l'opérateur, après avoir ouvert le volet 31 et introduit et fixé les conducteurs 27 aux bornes respectives 24, ferme le volet 31 selon la flèche F1 (figure 3) jusqu'à butée et éventuellement encliquetage du volet, ce qui a pour effet de presser selon la flèche F2 (figure 4) le faisceau 28 de conducteurs et de réduire son foisonnement ; la direction de la flèche F2 est sensiblement parallèle à la direction d'introduction des extrémités des conducteurs dans les ouvertures 26 des bornes ; on confirme ainsi la fixation des conducteurs dans les bornes sans risquer leur extraction et, pour loger un nombre donné de conducteurs, on peut ainsi se contenter d'un bornier moins large que les borniers classiques. Puis l'opérateur ferme la porte 32 selon la flèche F3 et la porte confirme la fermeture du volet 31 au moyen d'éléments de forme appropriés.

Des inscriptions 36 relatives à des informations de nature différente de celles portées extérieurement sur la porte 32 et relatives notamment au câblage peuvent avantageusement être ajoutées sur la face interne du volet pivotant 31 ; la porte 32 porte sur sa face extérieure 32b des inscriptions 37 relatives au type ou au fonctionnement du module ou aux organes qui lui sont reliés.

## Revendications

1. Bornier pour appareil d'automatisation, notamment pour automate programmable, comprenant :
- un corps de bornier (21) qui est susceptible d'être fixé de manière amovible et électriquement connecté à un module électronique de traitement (10) et qui comporte des bornes (24) connectées, d'une part, à des éléments de connexion du module et, d'autre part, à des extrémités de conducteurs souples (27) reliés à des organes du système automatisé,
- les bornes comprenant vers l'avant des ouvertures (25) d'accès à un outil et latéralement des ouvertures (26) d'introduction pour les extrémités des conducteurs,
- une goulotte verticale (29) pour loger le faisceau (28) des conducteurs,
- une paroi (32) de fermeture avant et des parois latérales (30),
caractérisé par le fait que la paroi latérale (30) située du côté des ouvertures latérales (26) d'introduction pour les conducteurs comprend un volet (31) pivotant latéralement.

2. Bornier selon la revendication 1,
caractérisé par le fait que le volet (31) pivotant latéralement est appliqué en cours de fermeture sur le faisceau (28) de conducteurs pour comprimer celui-ci selon une direction (F2) sensiblement parallèle à la direction d'introduction des conducteurs dans les ouvertures latérales (26).

3. Bornier selon la revendication 1 ou 2,
caractérisé par le fait que la paroi (32) de fermeture avant est une porte pivotante, le volet pivotant et la paroi pivotante tournant autour d'axes parallèles (X-X', Y-Y').

4. Bornier selon l'une des revendications 1 à 3,
caractérisé par le fait que le volet pivotant (31) porte intérieurement des inscriptions (36) de nature différente de celles (37) portées sur une face extérieure (32b) de la porte pivotante (32).

5. Bornier selon l'une des revendications 1 à 4,
caractérisé par le fait que la fermeture du volet pivotant (31) par rapport au corps de bornier (21) est confirmée par des éléments d'arrêt ou d'encliquetage.

6. Bornier selon l'une des revendications 3 et 5,
caractérisé par le fait que la porte pivotante (32) coopère en position de fermeture avec le volet pivotant (31) pour confirmer la fermeture de celui-ci.
